# EUROPÄISCHE PATENTSCHRIFT

(11) **EP 2 478 295 B1**
(45) Veröffentlichungstag und Bekanntmachung des Hinweises auf die Patenterteilung: **09.11.2016**
(21) Anmeldenummer: 10776287.4
(22) Anmeldetag: 09.09.2010
(51) Int. Cl.: F28D 15/02, H01L 23/427, H01L 23/467, F21V 29/71, F21V 29/74, F21V 29/75, F21V 29/76, F21V 29/00

(54) **KÜHLVORRICHTUNG FÜR EINE WÄRMEQUELLE**
COOLING DEVICE FOR A HEAT SOURCE
DISPOSITIF DE REFROIDISSEMENT POUR UNE SOURCE DE CHALEUR

(30) Priorität: 17.09.2009 DE 202009012555 U; 09.04.2010 DE 202010000549 U
(43) Veröffentlichungstag der Anmeldung: 25.07.2012
(73) Patentinhaber: Kunstwadl, Hans, 85570 Markt Schwaben (DE)
(72) Erfinder: KUNSTWADL, Hans, 85570 Markt Schwaben (DE); HADDAD, Dr. Abdallah, 80337 München (DE); LIN, Dr. Song, Chellaston, Derbyshire DE73 6PR (GB); DONALDSON, Jamie, Bedlington, Northumberland NE22 6DN (GB)
(74) Vertreter: Neidl-Stippler, Cornelia
(86) Internationale Anmeldenummer: PCT/DE2010/075087
(87) Internationale Veröffentlichungsnummer: WO 2011/032554

(56) Entgegenhaltungen:
- WO-A1-2007/053939
- DE-U1-202008 010 977
- US-A1- 2004 182 543
- US-A1- 2006 144 580
- US-A1- 2007 103 871
- US-A1- 2007 279 909
- US-A1- 2008 116 475
- US-A1- 2009 147 522
- US-A1- 2009 213 592

## Beschreibung

Die Erfindung betrifft eine Kühlvorrichtung zur Kühlung einer Wärmequelle, beispielsweise eines LED-Moduls gemäß dem Oberbegriff des Anspruchs 1, wie sie z. B. als LED-Lampen zum Beleuchten von Innenräumen und in einigen Außenbereichen (z. B. Tunnel, Gartenanlagen, Gebäudebestrahlung) Verwendung finden.

Als Lichtquellen werden häufig LED's (lichtemittierende Diode) verwendet. LEDs sind elektronische Halbleiter-Bauelemente. Fließt durch die Diode Strom in Durchlassrichtung, so strahlt sie Licht. Leuchtdioden besitzen eine exponentiell ansteigende Strom-Spannungs-Kennlinie, die unter anderem auch von der Temperatur abhängt. Der Lichtstrom ist nahezu proportional zum Betriebsstrom. Die Flussspannung stellt sich durch Betrieb an Konstantstrom ein, besitzt Exemplarstreuungen und ist temperaturabhängig - sie sinkt mit steigender Temperatur wie bei allen Halbleiterdioden ab. Hohe Temperaturen (gewöhnlich durch hohe Ströme) verkürzen die Lebensdauer von LEDs drastisch.
Typischerweise werden mehrere Lichtemittierende Dioden gemeinsam auf einem Träger zu einer umgangssprachlich als "LED"-Leuchte bezeichneten Einheit angeordnet, die nun auch nachfolgend als LED bezeichnet wird. Die Helligkeit einer LED wächst mit der Leistungsaufnahme. Bei konstanter Halbleitertemperatur ist die Zunahme annähernd proportional. Der Wirkungsgrad sinkt mit steigender Temperatur, deshalb sinkt die Lichtausbeute an der Leistungsgrenze je nach Art der Kühlung ab. LED's haben generell eine schlechte Wärmebeständigkeit, weswegen sie für Langzeitgebrauch gekühlt werden müssen, damit ihre Lebensdauer nicht extrem verkürzt wird. Besonders wärmesensibel sind hochbestückte LED Module, also Module die mit vielen lichtemittierenden Dioden versehen sind, wie z. B. die Fortimo DLM Line von Philips, oder XLM von Xicato, oder BXRA von Bridgelux und andere.

Die durch den Betriebsstrom als thermischer Verlustleistung erzeugte Wärme darf das Modul am definierten Gehäusemesspunkt nicht über 65°C aufheizen um die vorgegebene Lumen Leistung (Lichtstromeinheit -> Leuchtstärke) und die geforderte Lebensdauer (min 50.000 Betriebsstunden) gewährleisten zu können.

Um diese zu erreichen sind bereits unterschiedliche Vorkehrungen getroffen worden.

So wurde versucht, über am die LED's umfassenden Gehäuse oder mit diesen thermisch verbundene Anordnungen mit Kühlkörpern (passive Kühlung) durch freie Konvektion zu kühlen, z. B. durch diverse Lamellenanordnungen. Abgesehen davon, dass hierfür sehr viel Raum benötigt wird, stellen diese zudem ineffiziente Kühlkörper auch relativ schwere Metallelemente dar, insbesondere bei Anordnung einer größeren Anzahl von LED's im Modul oder Lampenkörper (DE 10 2007 030 186 B1, DE 20 2008 906 325 U1).
Ferner ist bekannt, aktiv bewegte Elemente zur Kühlung zu benutzen (aktive Kühlung), wofür in Verbindung mit Konvektionselementen motorisch angetriebene Lüfter oder eine schwingende Membran verwendet wird, siehe "Application guide, Philips Fortimo LED downlight module system (DLM)", Seite 18, Abb.: SynJet cooling System von Nuventix. Abgesehen davon, dass diese Elemente zu ihrer Funktion zusätzliche Energie benötigen, verursachen sie sehr störende Geräusche (über 20 db), die insbesondere bei Anordnung vieler solcher Leuchten an abgehängten Decken größerer Räume zu sehr hohen Resonanzen führen, zudem treten Vibrationen und Echoeffekte auf, die sich zu einer äußerst störenden Geräuschkulisse aufschaukeln können, bis zu fünffacher Vervielfältigung. Zudem sind die vorgesehenen seitlichen Lamellen-Kühlkörper nicht geeignet und auch nicht dafür vorgesehen, um die notwendige Temperaturreduktion zu ermöglich. Sie dienen nur zur Wärmespreizung. Daher konnten diese Leuchten bislang nur sehr bedingt eingesetzt werden.
Schließlich ist bekannt, zur Wärmeableitung Anordnungen mit Wärmeleitrohren (heat-pipes) einzusetzen.
So sind z. B. aus den DE 10 2007 038 909 A1 und DE 10 2006 045 701 A1 Kühlvorrichtungen mit Wärmeleitrohren bekannt, bei denen die einen Enden der Wärmeleitrohre mit einer Wärmequelle thermisch verbunden sind, während deren äußeren Teilbereiche zur Wärmeabgabe mit einem mit Lamellen bestückten oder lamellenähnlichem Kühlkörper versehen sind. Abgesehen davon, daß es sich hierbei um Anordnungen handelt, die nur im Outdoor-Einsatz in Kraftfahrzeugen und nicht für in Innenräumen zu verwendende Leuchten sinnvoll einsetzbar sind, also nicht für Indoor-Anwendungen, handelt es sich um direkt am Rohrmantel ausgeformte Kühl-Gewinde und wenig effektive Kühlkörper oder um ein Lamellenpaket, das an Wärmeleitrohren unterschiedlichen Inhalts und Zweckbestimmung aufgebracht sind. Zum Kühlen von Lampen in Gebäude-Räumen sind diese Kühlvorrichtungen nicht geeignet. Aus der EP 1903278 A1 und der DE 20 2009008456U1 sind gattungsgemässe Kühlvorrichtungen bekannt, die aber noch nicht zufriedenstellend herstellbar und/oder ausreichend effizient und raumsparend - insbesondere für die Anwendung in Beleuchtungskörpern - sind.

Siehe auch DE202008010977U, US2006/0144580, US2004/0182543 und US2007/0103871.

Aufgabe der Erfindung ist es somit, eine gattungsgemäße raumsparende Kühlvorrichtung für effektive geräuschlose Kühlung von Leuchten mit einer hohen LED-Anzahl zu schaffen.

Die Aufgabe wird durch eine Kühlvorrichtung mit den Merkmalen des Anspruchs 1 gelöst. Vorteilhafte Ausgestaltungen ergeben sich aus den abhängigen Ansprüchen.
In einer erfindungsgemäßen Kühlvorrichtung sind Grundelemente: mindestens ein, bevorzugz zwei, drei oder mehr Wärmeleitrohre, die sich in einer gemeinsamen Ebene erstrecken und deren jeweils ein (erster) Endabschnitt in einem an der Wärmequelle anzuschließenden Grundkörper eingelassen ist, während an dem anderen (zweiten) End-Teilbereich ein aus mehreren Lamellen bestehender Kühlkörper angebracht ist. Die Wärmeleitrohre sind über die gesamte Länge des Grundkörpers so angeordnet, dass die Wärmequelle oder das LED-Modul, an der Basisfläche des Grundkörpers anliegt. Die Wärmeleitrohre verlaufen dabei parallel zueinander und zu den Metall-Kontaktflächen, parallel zur Wärmequelle mit der heißesten Zone (hot-spot). An der Außenseite des Grundkörpers sind Lamellen einteilig mit diesem vorgesehen. Somit verlaufen die Wärmerohre mit ihrem einen Ende in unmittelbarer Nähe entlang der heißen Basis des LED-Moduls über dessen gesamte Länge, so dass eine sehr gute Wärmeleitung von der Wärmequelle zum Wärmeleitrohr sicher gestellt ist. Zudem wird bereits in der Zone des Grundkörpers und gleichzeitig der Wärmequelle über die Grundkörper-Lamellen gekühlt, wodurch insgesamt wesentlich zur Wärmeableitung beigetragen wird.
Es ist günstig, dass die Grundkörper-Lamellen, die unterschiedlich ausgeführt sein können, in Quer- oder Längsrichtung am Grundkörper vorgesehen sind. Bei im wesentlichen U-förmiger, das U-förmige Metall-Gehäuse des quaderförmigen LED-Moduls entsprechend zumindest teilweise umgreifender Ausbildung des Grundkörpers bietet sich an, auch die Lamellen U-förmig in axialer Aufeinanderfolge quer anzuordnen. Fertigungstechnisch einfacher ist jedoch, wenn die Kühlrippen oder Lamellen sich in Längs- bzw. Axialerstreckung ausgerichtet sind. Dadurch ist der Grundkörper insgesamt durch Extrusion oder Strangpressen einstückig herstellbar.

Es kann von Vorteil sein, wenn zwei oder drei oder mehr stets in einer gemeinsamen Ebene verlaufende Wärmeleitrohre für eine Kühlvorrichtung verwendet werden. So können drei Wärmeleitrohre gemeinsam zum Einsatz kommen, die bspw. einen Rohrdurchmesser von 5 mm besitzen, wobei die Anordnung der Wärmeleitrohre so gewählt wird, dass deren erster Endabschnitt im Grundkörper in entsprechenden Öffnungen und in entsprechender achsparalleler Beabstandung zueinander formschlüssig und wärmeleitfähig eingebettet sind, während sie nach Austritt aus dem Grundkörper in unterschiedlicher Form weitergeführt sind. So wird bspw. ein mittiges Wärmeleitrohr axial in gerader Ausrichtung weitergeführt, während die beiden seitlichen Wärmeleitrohre auseinanderlaufend weitergeführt werden und der Abstand zwischen den Wärmeleitrohren über eine relativ kurze Strecke zur besseren Wärmeableitung vergrößert wird, wonach sie dann im Kühlkörper selbst achsparallel weitergeführt werden, sodass insgesamt eine gabelförmige Anordnung der Wärmefeitrohre vorliegt. Über den gesamten zweiten End-Teilbereich der Wärmeleitrohre erstreckt sich der im Wesentlichen aus vielen parallelen, beabstandeten Lamellen bestehende Kühlkörper. Die Lamellen sind in vorteilhafter Weise so ausgebildet, dass Durchgangsbohrungen für den Durchtritt der Wärmeleitrohre so ausgeformt sind, dass die Wärmeleitrohre fest in Press- oder Schrumpfsitz mit den Lamellen in enger, wärmeleitender formschlüssiger Verbindung stehen, wodurch optimale wärmeleitende Kontakte zwischen den Wärmeleitrohren und den Lamellen sicher gestellt werden.

Um einfach einen konstanten Abstand zwischen den Lamellen zu erhalten, können unterschiedliche Abstandselemente verwendet werden. Diese können z. B. jeweils einfache Abstandsringe an den beiden äußeren Wärmeleitrohren sein. Sie haben senkrecht aus den Lamellen aufragende Abstandshalter, die beim Stanz-Herstellen der Lamellen gleich zungenartig eingeschnitten und senkrecht herausgebogen werden.

Bei einer Ausführungsform mit nur zwei Wärmeleitrohren sind diese ähnlich geformt, wie die beiden äußeren Wärmeleitrohre der vorbeschriebenen Ausführung mit drei Wärmeleitrohren. So verlaufen ebenfalls die ersten End-Teilbereiche der Wärmeleitrohre im Inneren des Grundkörpers parallel zueinander, dann nach Austritt aus dem Grundkörper auseinanderstrebend und bei Eintritt in den Kühlkörper wieder parallel zueinander, so dass in etwa die Form einer Stimmgabel vorliegt. Hier kann es sinnvoll sein, Wärmeleitrohre mit einem etwas dickeren Durchmesser zu wählen, z. B. mit 6 mm, so dass insgesamt ähnliche thermische und Festigkeitsverhältnisse vorliegen wie bei Anordnung von drei Rohren mit einem Durchmesser vom 5mm.

Die Wärmeleitrohre können in einer ersten Ausführungsform in axialen bzw. Längsbohrungen im Grundkörperbasisteil auf dessen gesamter Länge formschlüssig eingelassen sein, wobei sie keinen direkten körperlichen Kontakt mit der heißen Zone des LED-Moduls besitzen. Durch die gute Leitfähigkeit des Grundkörpers, besonders des Basisteils, in dem die Wärmeleitrohre eingebettet sind, kann die vom Grundkörper durch dessen engen Kontakt mit der heißen Zone des abzukühlenden Moduls aufgenommene Wärme gut an die Rohre übertragen werden und aktives Verdampfen des in den Wärmeleitrohren befindlichen fluiden Mediums unter Aufnahme latenter Wärme und damit das Ableiten in die nachfolgende Kühlzone mit Kondensation und Freisetzung der latenten Wärme erfolgen.

Meist werden die Wärmeleitrohre durch die Wärmeaufnahmeplatte gesteckt. Bei einigen Anwendungen ist es aber vorteilhaft, wenn die Wärmeleitrohre jeweils in eine zur Kontaktfläche des Grundkörper-Basisteils offene Nut eingelegt sind. Dabei können für maximale Kontakt und Formschluß die Nuten im Querschnitt im Wesentlichen U-förmig ausgebildet sein, mit einem Nut-Grund gleichen Durchmessers wie derjenige der Wärmeleitrohre und einer Nuthöhe entsprechend der Dicke der Wärmeleitrohre. Dadurch findet bei sattem flächigem Kontakt mit dem LED-Modul im Grundkörper gleichzeitig direkter Kontakt zwischen den Wärmeleitrohren und der heißen Basisfläche des LED-Moduls statt. Hierdurch wird ein besonders guter thermischer Kontakt hergestellt, so dass das Verdampfen des Mediums der Wärmeleitrohre und damit die Wärmeableitung am effizientesten erfolgen kann.

Erfindungsgemäß kann der Grundkörper unterschiedliche Ausführungsformen haben. So kann er als einfache Platte ausgebildet sein, auf bzw. an der ein LED-Modul entsprechend gut kontaktierend befestigt sein. Dabei weist die Platte an ihrer ebenen Außenseite entsprechend senkrecht abragende Lamellen auf, die längs oder quer zum Verlauf der darin angeordneten Wärmeleitrohre verlaufen können.

Der Grundkörper kann aber auch so ausgebildet sein, dass er die Wärmequelle bzw. das LED-Modul zumindest teilweise U-förmig seitlich umgreift, also selber eine U-Form besitzt. Somit weist der Grundkörper ein Grundkörperbodenabschnitt auf, worin in entsprechenden Bohrungen oder Nuten die Wärmeleitrohre teilweise verlaufen, sowie zwei zu diesen senkrecht verlaufende Seiten. Dabei ist der Abstand zwischen den beiden Grundkörperseiten so auszulegen, dass deren innere Flanken möglichst flächig kontaktierend und somit wärmeleitend an den Metall-Flanken des LED-Moduls anliegen. Um diesen Kontakt herzustellen, können die Grundkörperseiten auch seitlich durch Befestigungsmittel an den Flanken des LED-Moduls angebracht werden.

Ferner können die Grundkörperseitenwände entlang der Flanke des LED-Moduls länger oder kürzer verlaufen.

So ist bspw. eine Grundkörperseitenlänge von nur ca. 0,5 bis 15 mm, bevorzugt 8 mm, vorstellbar, die nur noch als Fixierhilfe dient. Die kurze Grundkörperseite-Ausführungsform hat den großen Vorteil, dass mehr Spielraum zur Anbringung eines zu verwendenden Leuchtengehäuses bleibt, das am unteren Teil des LED-Moduls eingreift bzw. an diesem befestigt ist.

Bei einer weiteren Ausführungsform ist der Grundkörper oder zumindest sein Grundkörperbodenabschnitt relativ dünn. Die Dicke des Grundkörperbodenabschnitts ist geringer als der Durchmesser der Wärmeleitrohre. Dabei sind auch hier entsprechende, zur Kontaktfläche offene Nuten für die einfache Aufnahme der Wärmeleitrohre vorgesehen, während das dünne Material des Grundkörpers bogenförmig um diese Nuten herum geführt ist. Zudem ragen die an der Vorderseite des Grundkörpers vorgesehenen Lamellen senkrecht von der Außenfläche des Grundkörperbodenabschnitts ab, so dass eine optimale Wärmeableitung, bei sehr wirtschaftlicher Materialverwendung vorhanden ist.

Bei langen U-förmig umgreifenden Grundkörperseitenwänden und axial weisenden Lamellen können zusätzlich zu den vom Grundkörperbodenabschnittteil nach außen abstehenden Lamellen auch noch seitliche Lamellen vorgesehen sein. Aus Raumgründen können diese dann ebenfalls eine zumindest teilweise winkelig nach oben verlaufen. Bei nur sehr kurzen Seitenwänden sind keine seitlichen Lamellen vorzusehen, da nur wenig Wärme in den kurzen Stummel-Grundkörperseiten aufnehmbar und daher abführbar ist.

Da hier die zu kühlende Wärmequelle, hier das LED-Modul, mehrere Befestigungseinrichtungen, bspw. Bohrungen, in besonderer Anordnung besitzt, sind diese auch im Grundkörperbodenabschnitt selbst vorzusehen. So weist z.B. das Fortimo-Modul drei Befestigungsbohrungen auf, die in Form eines gleichschenkeligen Dreiecks angeordnet sind.

Besonders vorteilhaft ist, wenn zusätzlich zu den üblichen drei Bohrungen (zwei vorne, eine mittig hinten) noch weitere drei Bohrungen vorgesehen werden, die spiegelbildlich zu ersteren angeordnet sind, nämlich eine mittige Bohrung an der vorderen äußeren Kante und zwei zueinander beabstandete Bohrungen an der Innenkante des Grundkörpers. Dadurch kann der Grundkörper einfach auf einem LED-Modul um 180° umgesetzt und befestigt werden, so dass das LED-Modul entweder mit seiner elektrischen Anschluss-Seite nach außen oder nach innen weisend gegenüber der gesamten Vorrichtung anordenbar ist. Dies ist insbesondere bei Verwendung der Kühlvorrichtung nicht nur für z. B. die quadratischen Fortimo LED-Module, sondern auch für die gleiche Breite, jedoch ca. doppelte Länge aufweisenden Lexel-Module von Philips der Fall. Der Grundkörper kann so auf das Modul aufgesetzt werden, dass er mit dem äußeren Ende des LED-Moduls frontseitig abschließt, wobei dann z. B. die Strom-Anschlussseite des LED-Moduls über die Innenkante des Grundkörpers weit nach innen in Richtung des Kühlkörpers herausragt. In dieser Anordnung befindet sich die heiße Zone in der dem elektrischen Anschlussende entfernteren Modulzone. Bei umgesetzter Verwendung des Moduls, also mit den Strom-Anschlussteil nach außen weisend, sitzt der wärmeableitende Grundkörper der Kühlvorrichtung auf der dann inneren Zone, so dass die innere Frontseite des Grundkörpers bündig mit der entsprechenden Frontseite des LED-Moduls abschließt.

Bei einer Anordnung mit innen liegendem Stromanschluss des LED-Moduls ist dafür Sorge zu tragen, dass ein entsprechender Innenabstand zwischen Grundkörper und Kühlkörper vorhanden ist. Dies kann u. a. dadurch erreicht werden, dass die Wärmeleitrohre umgekehrt verwendet werden, nämlich mit dem für einen formschlüssigen Kontakt mit den Lamellen unbrauchbaren Crimp-Ende nicht weit aus der letzten Lamelle herausragend, sondern mit diesem Ende in die Nut des Grundgehäuses eingelegt. So kann das gesamte Lamellenpaket des Kühlkörpers bis ganz nahe an das nun nach außen weisende glatte Ende herangeschoben befestigt werden.

Bei einer weiteren Ausführungsform sind mindestens ein, bevorzugt zwei zueinander beabstandete Auflage- oder Stützbleche zur vertikalen Abstützung des Kühlkörpers vorgesehen. Dadurch wird das gesamte Kühllamellen-Paket des Kühlkörpers nur durch drei vom Grundkörper abragende Wärmeleitrohre getragen. Die Wärmeleitrohre sind meist aus relativ weichem gut wärmeleitfähigem Material wie Aluminium oder Kupfer gefertigt und verbiegen sich sehr leicht unter dem Gewicht des Lamellenpakets oder durch unsachgemäßes Handhaben, werden somit leicht beschädigt.

Die Auflagen- oder Stützbleche können flächig bzw. linear einfach an der Unterseite bzw. Unterkante der Lamellen abstützend anliegen. Sie können aber auch in besonders vorteilhafter Weise in entsprechende vertikale Schlitze der Lamellen formschlüssig eingreifen, so dass nicht nur eine vertikale, sondern gleichzeitig auch eine gute seitliche Abstützung vorliegt. Das Auflageblech kann unterschiedlich ausgelegt werden, insbesondere dessen Länge, wobei dessen erstes Ende an den Seitenflächen des Moduls oder des Grundkörpers anbringbar ist, während sich sein zweites, konsolenartig abragendes längeres Ende zumindest über den Großteil der Länge des Kühlkörpers erstrecken sollte

Vorteilhaft ist, wenn die Auflagenbleche an deren oberen, den Lamellen zuweisenden Seite und in der Länge des entsprechenden Kontaktes, schräg nach oben, mit Neigung bzw. Steigung ausgebildet sind. Dabei ist bereits eine geringe Steigung von bevorzugt bis 5° oder höchstens bis 18° bereits äußerst wirkungsvoll, da damit das gesamte Lamellenpaket mit Wärmeleitrohren zum Kühl-Ende schräg nach oben gerichtet verläuft, wodurch der Kondensattransport gravitationsunterstützt abläuft. Durch eine nur geringfügige Schrägstellung der Wärmeleitrohre erfolgt eine wesentlich schnellere Rückführung des abgekühlten Mediums innerhalb der Wärmeleitrohre hin zum ersten, heißen Verdampfungsende. So kann durch eine äußerst einfache Maßnahme eine fühlbare höhere Kühlwirkung erzielt werden, gepaart mit erhöhter Festigkeit und Sicherheit. Bspw. kann für deren Verwendung an nicht quadratischen Wärmequellen, mit größerer Längsabmessung und in umgekehrter Anordnung, d. h. mit den elektrischen Anschlüssen der Wärmequelle oder des Leuchtengehäuses nicht nach außen, sondern nach innen in Richtung auf die Lamellen-Kühlkörper weisend, der Abstand zwischen Grundkörper und Lamellen-Kühlkörper um mindestens 10 mm größer als für quadratische LED-Module ausgelegt sein.

Schließlich ist von Vorteil, wenn zumindest die Lamellen oder gar alle Teile der Kühlvorrichtung geschwärzt ausgeführt sind, denn schwarze Oberflächen strahlen mehr Wärme ab, als weiße oder metallisch blanke Flächen.

Nachfolgend wird der Erfindung anhand von Ausführungsformen unter Bezug auf die Zeichnung näher erläutert, auf die sie jedoch keinesfalls eingeschränkt ist. Es zeigen:
Fig. 1: eine perspektivische Ansicht einer ersten Ausführungsform der Kühlvorrichtung von oben,
Fig. 2: eine perspektivische Ansicht der Ausführungsform der Fig.1 von unten,
Fig. 3: eine perspektivische Ansicht von vorne und oben einer zweiten Ausführungsform mit Längslamellen des Grundkörpers,
Fig. 4: eine Ansicht von unten der Ausführungsform nach Fig.3,
Fig. 5: eine vordere Frontansicht der Ausführungsform nach Fig. 3 und 4,
Fig. 6: eine perspektivische Ansicht von oben und hinten einer dritten Ausführungsform mit ovalen Kühllamellen und nur kurz umgreifendem Kühlkörper,
Fig. 7: eine Perspektivansicht von unten des Ausführungsform nach Fig. 6,
Fig. 8: eine Ansicht von unten der Ausführungsform nach Fig. 6 und 7,
Fig. 9: eine vordere Frontansicht der Ausführungsform nach Fig. 6 bis 8,
Fig. 10: eine Frontansicht einer Ausführungsform ähnlich wie in Fig. 6, jedoch ohne Grundkörperseiten,
Fig. 11: eine Frontansicht auf eine Ausführungsform ähnlich wie Fig. 6, jedoch mit dickem Grundkörper-Grundkörperbodenabschnitt,
Fig. 12: eine Frontansicht einer Lamelle des Kühlkörpers gemäß der Ausführungsform nach Fig. 6,
Fig. 13: eine Seitenansicht der Lamelle nach Fig. 12 mit dem Abstandhalter,
Fig. 14: eine schematische Seitenansicht der Kühlvorrichtung, aufgesetzt auf ein LED-Modul und Lampengehäuse, in Ausführung mit schrägen Auflageblechen,
Fig. 15: eine schematische Seitenansicht einer Kühlvorrichtung, die aufgesetzt auf ein quadratisches LED-Modul,
Fig. 16: eine Ansicht ähnlich Fig. 15, wobei die Kühlvorrichtung auf ein langes LED-Modul, mit nach innen weisendem Stromanschluss aufgesetzt ist;
Fig. 17: eine ähnliche Anordnung wie in Fig. 16 mit langem LED-Modul, mit nach außen weisendem Stromanschluss;
Fig. 18: eine Ausführungsform mit Anordnung des Kühlkörpers oberhalb des LED-Moduls, in perspektivischer Ansicht;
Fig. 19: die Ausführungsform der Fig. 18 im Querschnitt.
Fig. 20: die Ausführungsform der Fig. 18 in perspektivischer Ansicht von Hinten
Fig. 21: die Ausführungsform der Fig. 18 in Ansicht von Vorne
Fig. 22: die Ausführungsform der Fig. 18 von der Grundplatte aus
Fig. 23: die Ausführungsform der Fig. 18 in Ansicht von Hinten
Fig. 24: eine Ausführungsform einer Kühllamelle mit Kleberrinne
Fig. 25: eine weitere Ausführungsform des Kühlkörpers in verschiedenen Ansichten
Fig. 26 eine Ausführungsform für Kühllamellenkörper für eine Punktlichtquelle in perspektivischer Ansicht
Fig. 27 Draufsichten auf den Kühllamellenkörper der Fig. 26
Fig. 28 eine Ausführungsform für Punktlicht-Kühlkörper mit Befestigung für Kühllamellenkörper der Fig. 26 und 27; und
Fig. 29 a - c Detailansichten einer Punktlicht-Kühllamelle

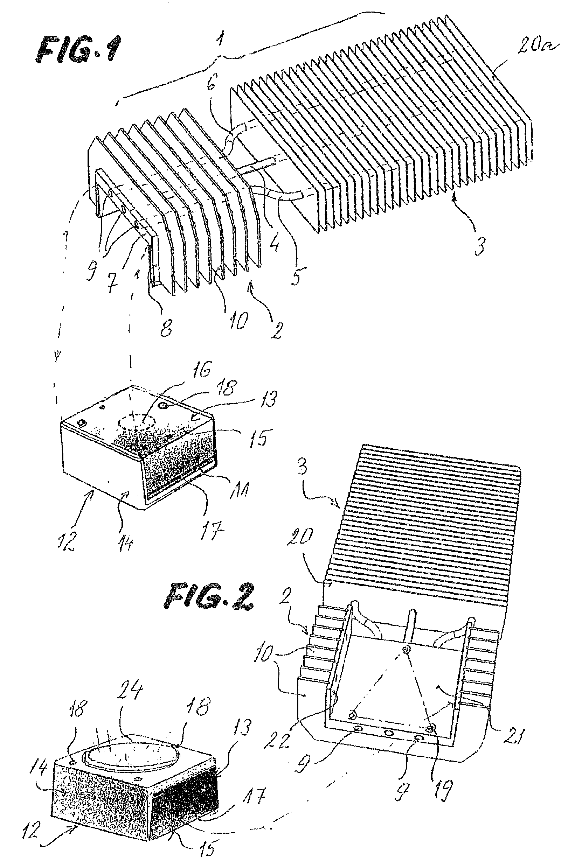

In Fig. 1 und 2 ist eine ersten Ausführungsform der Erfindung dargestellt, woraus ersichtlich ist, dass die erfindungsgemässe Kühlvorrichtung 1 im Wesentlichen aus drei Elementen besteht, einem Grundkörper 2, einem Kühlkörper 3 und Wärmeleitrohren 4, 5 und 6. Die Wärmeleitrohre 4, 5 und 6 verbinden die beiden Körper 2, 3. Die Wärmeleitrohre verlaufen zunächst innerhalb des Grundkörpers 2 mit zumindest geringem Abstand zueinander, wobei der erste Endabschnitt der Wärmeleitrohre 4,5 und 6 im Grundkörper 2 eingelassen ist, während der zweite Endabschnitt durch den Kühlkörper 3 hindurchgeführt wird. Der Grundkörper 2 ist in dieser Ausführungsform im Wesentlichen U-förmig, mit einem Grundkörperbodenabschnitt 7 und zwei Grundkörperseiten 8. Es ist erkennbar, dass im Grundkörperbodenabschnitt 7 des Grundkörpers 2 drei zueinander beabstandete Bohrungen 9 vorgesehen sind, in welchen die ersten Endabschnitte der Wärmeleitrohre 4, 5 und 6 verlaufen. Das LED-Modul 12, das gleichzeitig die abzukühlende Wärmequelle darstellt, ist hier quadratisch (z. B. ein Fortimo-Modul von Philips). Sein Körper ist aus zwei U-förmigen Gehäuseteilen zusammengesetzt: einem Metall-Gehäuseteil 13 und einem Kunststoff-Gehäuseteil 14. Das Metall-Gehäuseteil 13 besitzt einen nach oben weisenden Grundkörperbodenabschnitt 15, in dessen Mitte sich die heiße Zone 16 (hot-spot) befindet und an dessen gegenüber liegenden Enden sich Metall-Grundkörperseiten 17 mit entsprechenden äußeren Kontaktflächen erstrecken. Hier sind auch drei Befestigungsbohrungen 18 zu erkennen, die in Dreieckform angeordnet sind und zur Befestigung am Grundkörper 2 dienen. Hierfür sind am Grundkörperbodenabschnitt 7 drei Gewindebohrungen 19 in Dreiecksform angeordnet, die den drei Befestigungsbohrungen 18 im LED-Modul 12 entsprechen.

Ferner ist zu erkennen, dass die Kühlvorrichtung 1 an ihrem anderen Ende einen relativ langen Kühlkörper aus Kühlkörperlamellen 20 besitzt. Die Kühlkörperlamellen 20 sind hier einfache Rechtecke und sind mit konstantem Abstandung voneinander auf den Wärmeleitrohren 5, 6 aufgereiht.

Die Wärmeleitrohre 4, 5 und 6 sind im GrundkörperGrundkörperbodenabschnitt 7 mit relativ geringem Abstand parallel zueinander über dessen gesamte Länge geführt und treten an der Innenseite des Grundkörpers 2 mit entsprechendem Abstand voneinander aus. Dabei verläuft das mittlere Wärmeleitrohr 4 mittig, gerade und axial, während die beiden äußeren Wärmeleitrohre 5 und 6 zuerst schräg nach außen abgewinkelt, danach in entsprechend größerem Abstand voneinander erneut parallel zueinander verlaufen, so dass die Form einer Gabel mit drei Zinken erhalten wird. Auf dem Gabelzinken-Teil sind die Kühlkörperlamellen 20 des Kühlkörpers 3 aufgereiht.

In Fig. 2 ist das mit dem Grundkörper 2 zu verbindende LED-Modul 12 in perspektivischer Ansicht von oben gezeigt, wie es in den Grundkörper 2 eingelegt und mit ihm verschraubt wird. Sein Kunststoff-Gehäuseteil 14 weist nach oben und in seinem Boden oder Leuchtteil 24 sind ebenfalls die drei Befestigungsbohrungen 18 zu erkennen. Die Kontaktfläche 15 des U-förmigen Metall-Gehäuses liegt in montiertem Zustand genau auf der Kontaktfläche 21 des Grundkörpers 2 übereinstimmend auf, während die Metall-Grundkörperseiten 17 sich in thermischem Kontakt mit den Kontaktflächen 22 der Grundkörperseite 17 befinden.

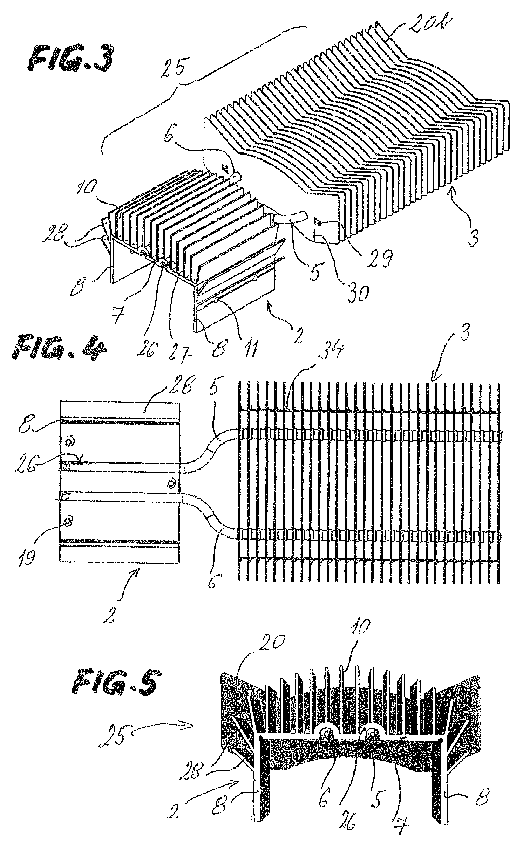

Fig. 3 zeigt eine zweite Ausführungsform einer Kühlvorrichtung 25. Die beiden Grundkörperseiten 8 des U-förmigen Grundkörpers 2 sind relativ weit vertikal abwärts gezogen, bis fast über die gesamte Seitenlänge des aufzunehmenden LED-Moduls. Besonders auffällig ist, dass die Kühlrippen oder Lamellen 10 hier nicht quer, sondern in Längs- bzw. Axialrichtung angeordnet sind. An der Oberseite des Grundkörperbodenabschnitts 8 sind sich senkrecht nach oben erstreckende Lamellen 10 über die gesamte Länge des Grundkörpers 2 vorgesehen, während an den Grundkörperseiten 8 jeweils zwei Seitenlamellen 28, schräg nach oben weisend, um in der Breite nicht allzu sehr ausladend hervorzustehen, vorgesehen sind. Die Längsanordnung der Lamellen 28 hat den Vorteil, dass bei erfindungsgemäßer einstückiger Ausbildung des Grundkörpers 2 die Möglichkeit besteht, z. B. durch Strangpressen in schneller und kostengünstiger Weise den Grundkörper 2 zu erteilen, wobei dann sogar die Nuten für die Wärmeleitrohre 4, 5, 6 gleich mit eingeformt werden und der Grundkörper 2 von einem langen Profilstück nur abgelängt werden und die notwendigen Befestigungsbohrungen 18 einzubringen sind.

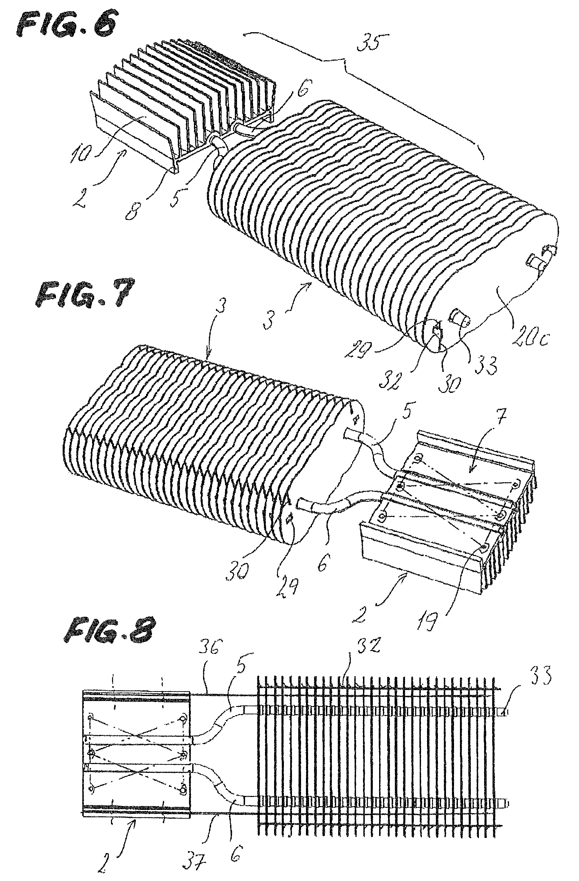

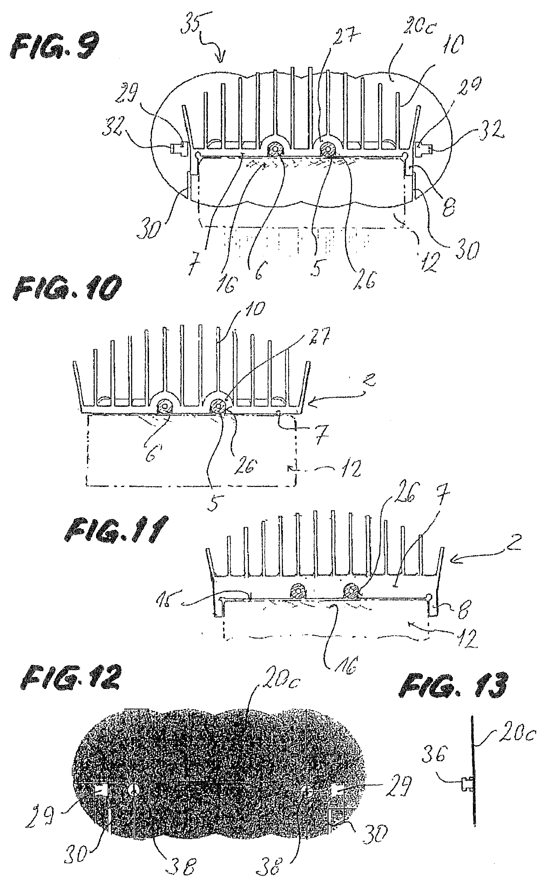

Als Besonderheit ist hier anzusehen, dass nicht mehr drei Wärmeleitrohre vorhanden sind, sondern nur zwei, nämlich die Wärmeleitrohre 5 und 6, die in Form und Anordnung denjenigen aus Fig. 1 entsprechen, wobei die beiden Wärmeleitrohre 5 und 6 eine Form ähnlich einer Stimmgabel mit zwei parallelen Zinken haben. Nicht zu erkennen ist, dass hier auch eine Dimensionsänderung der Wärmeleitrohre stattgefunden hat. Es werden hier bevorzugt nicht mehr drei Wärmeleitrohre mit Durchmesser 5 mm, sondern zwei Wärmeleitrohre mit 6 mm Durchmesser verwendet, so dass trotz Einsparung des mittigen Wärmeleitrohres die Festigkeit und der thermische Haushalt, also die Wärmeabfuhr, diesbezüglich im Wesentlichen gleich geblieben sind. Zur Ausbildung des Kühlkörpers 3 ist anzumerken, dass die Kühlkörperlamellen 20 im Vergleich mit denjenigen aus Fig. 1 nicht mehr eine einfache rechteckige Form aufweisen, sondern mittig domförmig nach oben geschwungen und jeweils seitlich nach oben abgewinkelt ausgebildet sind. Die Höhe der Kühlkörperlamellen 20 ist durchgehend gleich bleibend. Durch die geschwungene und/oder abgewinkelte Ausführung wird aber nur sehr geringfügig, höchstens um einige Millimeter, die Breite des Lamellenpaketes verringert. Zu erkennen sind auch zwei Stanzlöcher 29, die durch im Wesentlich U-förmiges Einstanzen und nach hinten Biegen um 90° je einer Zunge herstellbar sind (in dieser Ansicht nicht zu sehen), die als Abstandshalter 32 zwischen den einzelnen Kühlkörperlamellen 20 dienen. Deren Ausbildung und Anordnung ist aus Fig. 6 und 13 genauer ersichtlich und wird auch im Zusammenhang mit diesen Figuren entsprechend erläutert.

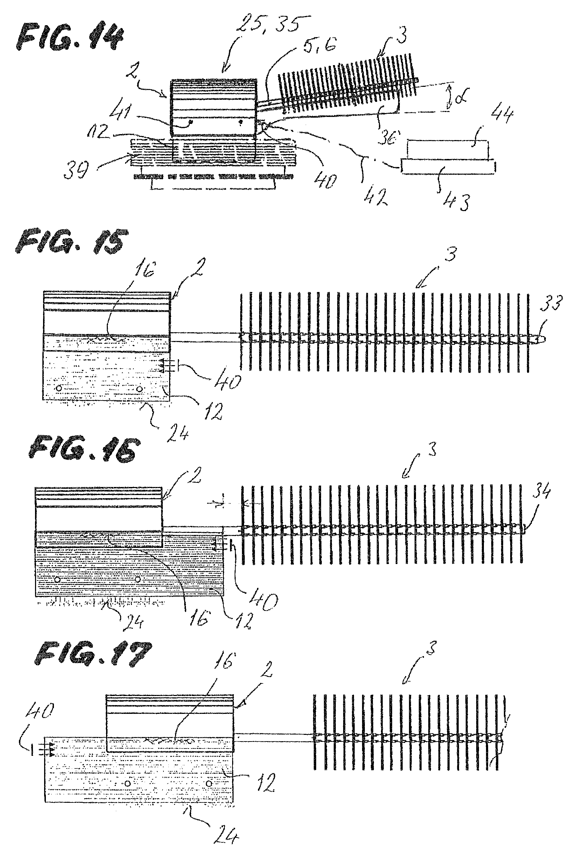

An den Kühlkörperlamellen 20 sind zudem vertikal von unten nach oben verlaufend zwei Schlitze 30 eingebracht, wobei hier nur einer der beiden Schlitze gezeigt ist. Die vertikalen Einsteckschlitze dienen jeweils zur Aufnahme eines Auflagebleches, wie aus den Fig. 8 und 14 zu ersehen und auch im Zusammenhang mit diesen Figuren nachfolgend beschrieben wird.

Fig. 4 zeigt die Kühlvorrichtung 25 aus Fig. 3 in Ansicht von unten, wobei zu erkennen ist, dass im Grundkörper 2 nahe der axialen Mitte zwei Nuten 26 vorgesehen sind, in denen die hier linken (Verdampfungs-) Endabschnitte der Wärmeleitrohre 5 und 6 auf ganzer Länge aufgenommen sind. In dieser Position werden diese Rohrenden bspw. durch festes Anschrauben am Grundkörper des entsprechend eingelegten LED-Moduls festgehalten. Hierfür dienen die drei Gewindebohrungen 19. Zu erkennen ist hier auch, wie die Seitenlamellen 28 seitlich schräg von den weit abwärts gezogenen Grundkörperseiten 8 des Grundkörpers abragen.

Im Kühlkörper 3 sind jeweils zwei nach hinten abgebogenen Abstandshalter 32 zu sehen, die jeweils nur als axialer Strich erscheinen, so dass eine optische Täuschung einer Linie, die ein kontinuierliches Blech darstellen könnte, vorliegt.

Die Frontansicht der Kühlvorrichtung 25 der Fig. 5 lässt die Anordnung der Vorrichtungsteile zueinander und deren Erstreckung in horizontaler und vertikaler Richtung erkennen. So ist die U-Form des Grundkörpers 2 mit relativ dünnem Grundkörperbodenabschnitt 7 gut erkennbar, die bogenförmig um die beiden Wärmeleitrohre 5, 6 geführt ist, so dass je U-förmige Nut 26 entsprechend dem Durchmesser der Wärmeleitrohre 5, 6 vorhanden ist.

An der Oberseite des Grundkörperbodenabschnitts 7 ragen die Längslamellen 10 vertikal ab, die für ein gefälligeres Aussehen und eine angenehmere Handhabung in ihrer vertikalen Länge in Querrichtung bogenförmig abgestuft sind. Diese Bogenform ist bis zu den beiden Seitenlamellen 28 fortgezogen. Die geschwungene Form der Kühlkörperlamellen 20 (20b) ist sehr gut zu erkennen, mit mittigem Bogen und seitlich nach oben abstehenden Flügelteilen. Auch hier ist zu erkennen, dass die Kühlkörperlamellen 20 im Wesentlichen durchgehend gleich hoch sind.

Fig. 6 bis 9 zeigen eine dritte Ausführungsform der erfindungsgemässen Kühlvorrichtung 35. Insbesondere ist aus Fig. 6, die eine perspektivische Ansicht von hinten zeigt, zu erkennen, dass der Grundkörper 2 in seinen wesentlichen Elementen ähnlich der Kühlvorrichtung 25 aus Fig. 3 zusammengesetzt ist. Bei dieser Ausführungsform sind die Grundkörperseiten 8 recht kurz. Sie ist eine bevorzugte Ausführungsform für die Fortimo-Moduln, die eine Länge von nur ca. 5 oder 8 Millimetern besitzen. Auch sind an diesen kurzen Grundkörperseiten 8 keine Seitenlamellen vorgesehen, sondern der Kühlkörper 2 weist nur vertikal nach oben weisende Lamellen 10 auf. Eine besondere Ausführung haben hier die Kühlkörperlamellen 20 (20c) erfahren. Sie sind nicht mehr gerade rechteckig oder als geschweift und abgebogenes Rechteck ausgebildet, denn sie weisen überhaupt keine rechten Ecken mehr auf, sondern haben eine im Wesentlichen ovale abgerundete Form. Die Kühlkörperlamellen 20c, sind zwar etwas kürzer als die vorhergehend beschrieben Kühlkörperlamellen 20a und 20b, weisen jedoch eine bedeutend größere Höhe bzw. Breite auf als diese, wie insbesondere aus dem Vergleich der Vorderansichten gemäß Fig. 5 und 9 ersichtlich ist. Es wird somit bei wesentlich vergrößerter Wärmeabgabefläche vertikal nach oben insgesamt nicht mehr Raum benötigt, jedoch in der Breite erheblich Platz eingespart, wodurch der Einbau und die Handhabung wesentlich verbessert worden sind. Zu diesen Eigenschaften trägt noch bei, dass keine Ecken am Lamelienpaket des Kühlkörpers vorhanden sind, sondern nur Rundungen, die angenehm in der Hand liegen und auch optisch vorteilhaft wirken.

Die Rückansicht des Kühlkörpers 3 aus Fig. 6 zeigt, wie aus der letzten Lamelle 20c die beiden Abstandshalter 32 senkrecht abragen, die durch im Wesentlichen U-förmige Einschnitte im Lamellenblech und anschließender Herausbiegen der ausgestanzten Zungen entstehen, wobei die Stanzlöcher 29 frei bleiben. Zudem ist zu sehen, wie die äußeren zweiten Enden der beiden Wärmeleitrohre 5 und 6 aus der Fläche der letzten Lamelle 20c herausragen. Bei dem relativ weit herausragenden Wärmeleitrohrabschnitt handelt es sich um das jeweilige Crimp-Ende 33 der Rohre, die Quetschungen aufweisen und somit in diesem Endbereich für die ordnungsgemäße formschlüssige Aufnahme der Lamellen nicht mehr ausreichend zylindrisch sind.

Fig. 7 veranschaulicht die Unterseite der Kühlvorrichtung 35, wobei am Kühlkörper 2 die Anordnung der Schlitze 30 und der Stanzlöcher 29 zu den nicht gezeigten Abstandshaltern erkennbar sind. Zudem ist sehr gut die Ausbildung der beiden Wärmeleitrohre 5 und 6 zu erkennen, nämlich die relativ enge Führung im Grundkörperbodenabschnitt 7, die nach dem Austritt aus diesem eine nach außen geschwungene Bogenform einnimmt und dann mit größerem Abstand zueinander parallele im Kühlkörper 3 weiter geführt werden..

Ferner ist hier die Anordnung der Gewindebohrungen 19 zu erkennen, die zur Befestigung am LED-Modul dienen. Hier sind nun nicht mehr nur drei Gewindebohrungen 19 in Dreieckanordnung vorgesehen, sondern zudem eine spiegelbildliche Verdoppelung dieser Anordnung, also sechs Bohrungen. Dies hat den Vorteil, dass das LED-Modul beliebig, d. h. um 180 ° gedreht am Grundkörper befestigbar ist, also eine Wahlmöglichkeit besteht, ob der Stromanschluss nach innen oder nach außen weisen soll.

Die besondere Anordnung der Gewindebohrungen ist auch aus Fig. 8 zu erkennen, die eine Ansicht von unten. Auch hier ist, ähnlich wie in Fig. 4, die aufeinander folgende Anordnung der Abstandshalter 32 zu erkennen, die Führung und Ausbildung der beiden Wärmeleitrohre 5 und 6, als auch die Anordnung der Auflagebleche 36 und 37. Letztere sind einerseits am Grundkörper 2 befestigt und greifen andererseits in die hier nicht erkennbaren Schlitzen 32 ein, wie jedoch vorhergehend in Zusammenhang mit Fig. 3, 6 und 7 bereits kurz ausgeführt.

Fig. 9 veranschaulicht die bereits vorgenannten Anordnungen und Größenverhältnisse der einzelnen Teile der Kühlvorrichtung 35, insbesondere des Kühlkörpers 2 mit seinem relativ dünnen Grundkörperbodenabschnitt 7, dessen bogenförmige Nuten 26 die Wärmeleitrohre 5 und 6 führen. Es ist auch erkennbar, wie die beiden Wärmeleitrohre 5 und 6 in ihren Nuten 26 in direktem Kontakt mit der heißen Zone 16 eines LED-Moduls 12 liegen. Zudem ist die wolkenartig-oval-eingekerbte Ausführungsform der Kühlkörperlamellen 20c des Kühlkörpers 3 in Anordnung und Breite sowie Höhenauslegung ersichtlich. Auch sind die beiden Schlitze 30 für die hier nicht dargestellten Auflagebleche sowie die Stanzlöcher 29 der zungenförmigen Abstandshalter 32 zu erkennen, von denen jeweils ein schmales Grundkörper bzw. unterer Verbindungsansatz zu sehen ist.

Fig. 10 zeigt in Frontansicht einen Grundkörper 2 ähnlich dem der Fig. 9, wobei aber die Grundkörperseiten fehlen und der gerade Grundkörperbodenabschnitt 7 als Platte mit Kühlrippen ausgebildet ist.

Fig. 11 zeigt eine weitere Ausführungsform des Grundkörpers 2 in Frontansicht, mit den Nuten 26 für die beiden Wärmeleitrohre 5, 6 sowie die Anordnung und Ausrichtung der Grundkörperlamellen 10. Der wesentliche Unterschied besteht in der Dicke des Grundkörperbodenabschnittes 7, ähnlich der Kühlvorrichtung 1 aus Fig. 1. Hier verlaufen die Wärmeleitrohre jedoch nicht in Längsbohrungen, sondern in zur Kontaktfläche 15 offenen U-förmigen Nuten 26. Selbstverständlich kann auch diese Ausführungsform mit dem dicken Grundkörperbodenabschnitt 7 auch ohne Grundkörperseite 8, also im Wesentlichen als an der Unterseite glatte Platte ausgeführt sein, ähnlich wie im Beispiel der Fig. 10.

Fig. 12 verdeutlicht eine Lamelle 20 der Kühlvorrichtung 35, deren wolkenartige ovale Ausbildung, die durch die oben und unten längssymmetrischen Einschnürungen oder Einkerbungen im weitesten Sinne an eine Erdnuss erinnert. Die Anordnung der beiden Schlitze 30 für Auflagebleche, Bohrungen 38 in der Lamelle zum Durchführen der Wärmeleitrohre sowie die Stanzöffnungen 39 sind zu erkennen. Es handelt sich hier um ein sehr einfach und kostengünstig herstellbares Stanzteil, das schnell und einfach in notwendiger Anzahl fertigbar ist. Außerdem ist zu erkennen, dass die Bohrungen 38 so zueinander und zu der oberen und unteren Kante beabstandet sind, dass ein Verhältnis untere Höhe zur oberen Höhe von bevorzugt ca. 2 : 3,5 vorliegt und ausreichend untere lichte Weite verbleibt, um gute Luftzirkulation trotz großer Höhe der Lamellen sicher zu stellen, wie insbesondere auch aus Fig. 9 ersichtlich.

Fig. 13 zeigt in Seitenansicht die Lamelle 20c aus Fig. 12 und die Form der daraus senkrecht herausgebogenen Abstandshalter 36.

Fig. 14 zeigt schematisch eine Kühlvorrichtung 25, 35 im Einsatz auf einem LED-Modul 12 in einem Lampengehäuse 39. Die in Längsrichtung sich erstreckenden Auflagebleche 36 sind seitlich am Körper 2 über Schrauben 41 befestigt. Die Auflagebleche 36 haben an ihrer Oberkante eine ansteigende Schräge von z. B. 3° bis 5°. Hierdurch wird einerseits das Lamellenpaket in vertikaler Richtung abgestützt, so dass die relativ weichen und daher leicht verbiegbaren Wärmeleitrohre 5 und 6 sowohl in vertikaler, als auch in horizontaler Richtung geschont werden. Andererseits ergibt sich durch die nach hinten ansteigende Schräge der Lamellen nach der Montage ein positiver Winkel "warme Seite" zu "kalte Seite". Damit wird der Kondensrücklauf durch die Schwerkraft unterstützt und somit der Wirkungsgrad der Einheit deutlich messbar verbessert.

Hier weist der Stromanschluss 41 des LED-Moduls 12 nach hinten, wobei eine Leitung 42 zu einer Verbindungsbox 43 eines LED-Treibers 44 führt. Durch die leichte Schrägstellung des Lamellenpakets wird auch etwas mehr untere lichte Weite erzielt, so dass auch die entsprechenden Anschlüsse leichter und störungsfreier nach hinten hin erfolgen können.

Fig. 15 bis 17 zeigen verschiedene Anordnungsmöglichkeiten der erfindungsgemäßen Kühlvorrichtungen 1, 25, 35, insbesondere des Grundkörpers 2 im Verhältnis zum rechteckigen LED-Modul. Durch deren Anordnung des Stromanschlusses nach vorne oder nach hinten auf das Lamellenpaket hin treten verschiedene Raum-Probleme oder -Erfordernisse auf..

Fig. 15 zeigt eine Anordnung ähnlich der Fig. 14, bei der ein Grundkörper 2 auf einem gleichlangen quadratischen LED-Modul 12 aufliegt. Die heiße obere Zone 16 des LED-Moduls 12 sowie dessen Leuchtzone 24 liegen mittig zum LED-Modul 12 und zum Grundkörper 2. Der Stromanschluss 40 weist nach hinten auf die Lamellen des Kühlkörpers 3. Da bei dieser Ausführungsform ein relativ großer Abstand zwischen der Rückfront des Grundkörpers 2 und der vorderen Lamelle des Kühlkörpers 3 vorhanden ist, besteht kein Platzproblem und ein Handhaben des Anschlusses ist problemlos.

In Fig. 16 ist die Anordnung des Grundkörpers 2 einer erfindungsgemäßen Vorrichtung auf einem sich relativ lang erstreckenden LED-Modul zu sehen, dessen Stromanschluss 40 nach hinten weist, wobei sich dessen heiße Zone 16 und die Leuchtzone 24 in der vorderen Hälfte des LED-Moduls befinden. Entsprechend ist auch der Grundkörper 2 auf dieser Vorderseite angebracht und fluchtet mit dessen Frontseite. Der Innen-Abstand zwischen Grundkörper und Kühlkörper ist so groß, dass für den Stromanschluss 40 ausreichend Platz bis zur ersten Lamelle des Kühlkörpers vorhanden ist. Der zusätzliche Raum wird dadurch erreicht, dass das gesamte Lamellenpaket des Kühlkörpers 3 auf den Wärmeleitrohren weiter nach außen verschoben ist. Zudem sind die Wärmeleitrohre mit den Crimp-Enden nicht nach rechts herausragend vorgesehen, sondern die Crimp-Enden (die eine verlorene Länge darstellen) sind in den Nuten des Grundkörpers 2, so dass das Lamellenpaket bis ganz außen an das glatte Ende 34 der Wärmeleitrohre angeordnet werden kann. Hierdurch können bis zu 10 mm Abstand bei gleicher Rohr- und Kühlkörperlänge gewonnen werden.

Fig. 17 zeigt die Kühlvorrichtung aus Fig. 15, 16 mit gedrehtem langem LED-Modul, dessen Stromanschluss 40 nun nach vorne frei zugänglich ist. Da die heiße Zone 16 an der den Kühlkörper-Lamellen zugekehrten Seite liegt, befindet sich der Grundkörper 2 auf dieser nun hinteren Zone des LED-Moduls so, dass die beiden hinteren Frontseiten von Grundkörper und LED-Modul vertikal miteinander fluchten.

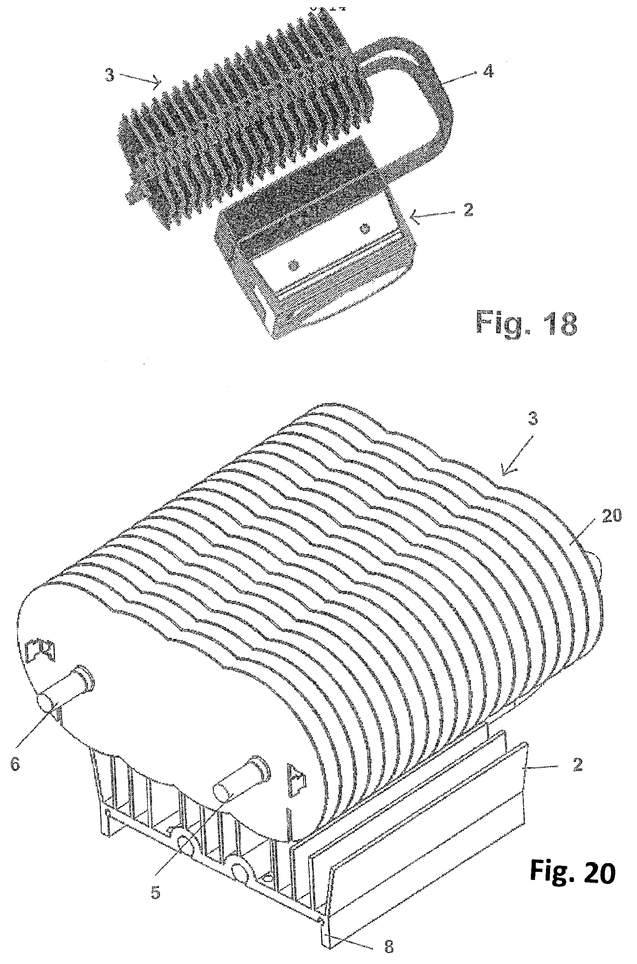

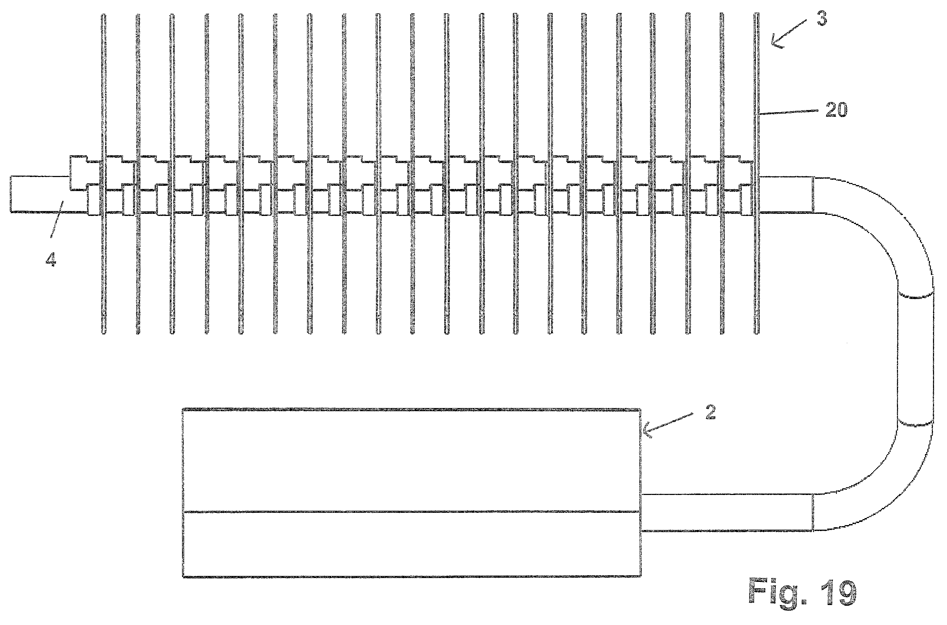

Fig. 18 stellt eine weitere Ausführungsform der Kühlvorrichtung für eine Wärmequelle für Orte, bei denen die Höhe der Kühlvorrichtung nebensächlich ist, aber seitlich Raum gespart werden soll, dar. Derartige Ausführungsformen eignen sich besonders für abgehängte Leuchten u. dgl. Dabei sind die Wärmeleitrohre (bei dieser Ausführungsform sind 2 Wärmeleitrohre dargestellt) in einer U-förmigen Ebene gebogen, so dass der Kühlkörper oberhalb des LED-Gehäuses liegt. Die Ausführungsform ist zum besseren Verständnis in Fig. 19 im Querschnitt gezeigt.

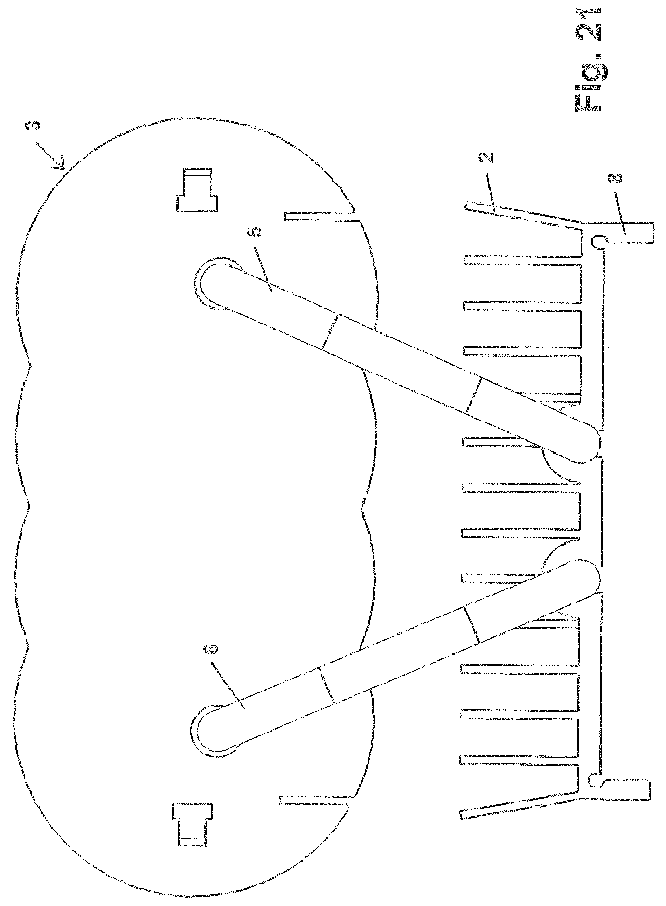

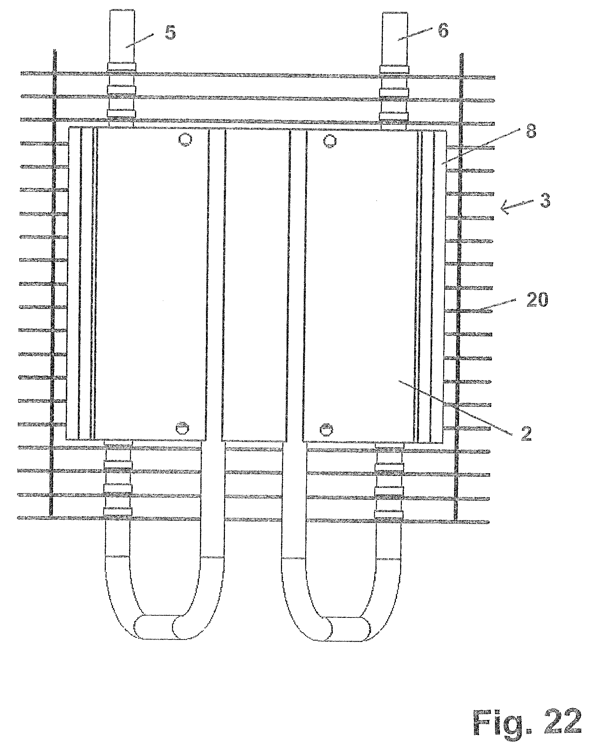

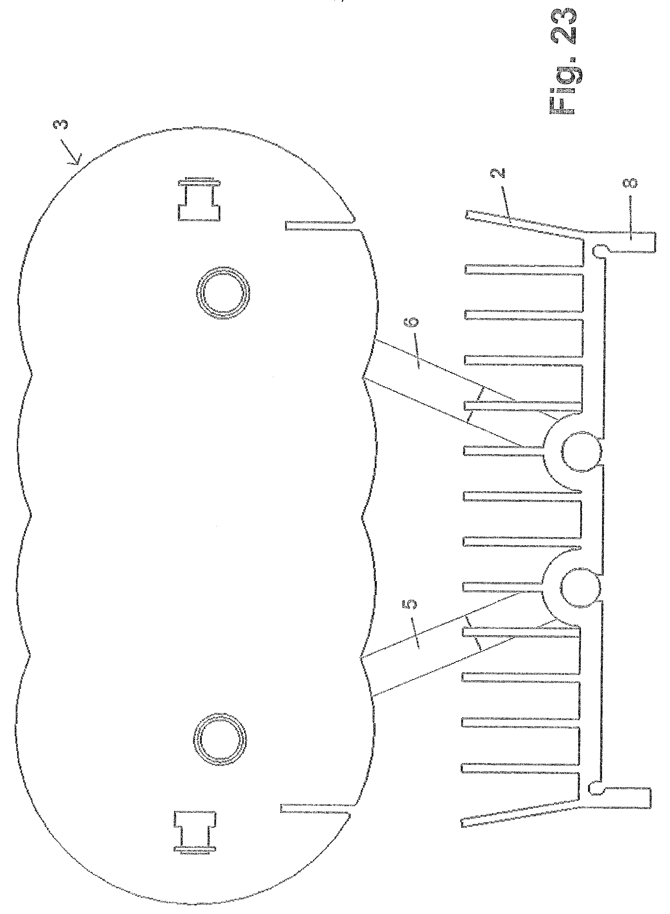

Fig. 20 bis 23 zeigen weitere Ansichten der Ausführungsform mit Kühlkörper über der LED. Deutlich ist ersichtlich, wie die Wärmeleitrohre vom Grundkörper 2 in den Kühlkörper 3 leiten und wie die Wärmeleitrohre 6,5 in Nuten im Grundkörper 2 aufgenommen sind. Der Grundkörper 2 ist bei dieser Ausführungsform ein stranggepreßtes Profil und einfachst herzustellen.

Fig. 20 bis 23 zeigen weitere Ansichten der Ausführungsform mit Kühlkörper oberhalb der LED. Deutlich ist ersichtlich, wie die Wärmeleitungsrohre vom Grundkörper 2 in den Kühlkörper 3 leiten und wie die Wärmeleitrohre 6, 5 in Nuten im Grundkörper aufgenommen sind. Der Grundkörper 2 ist bei dieser Ausführungsform als stranggepreßtes Profil ausgebildet und einfachst herzustellen.

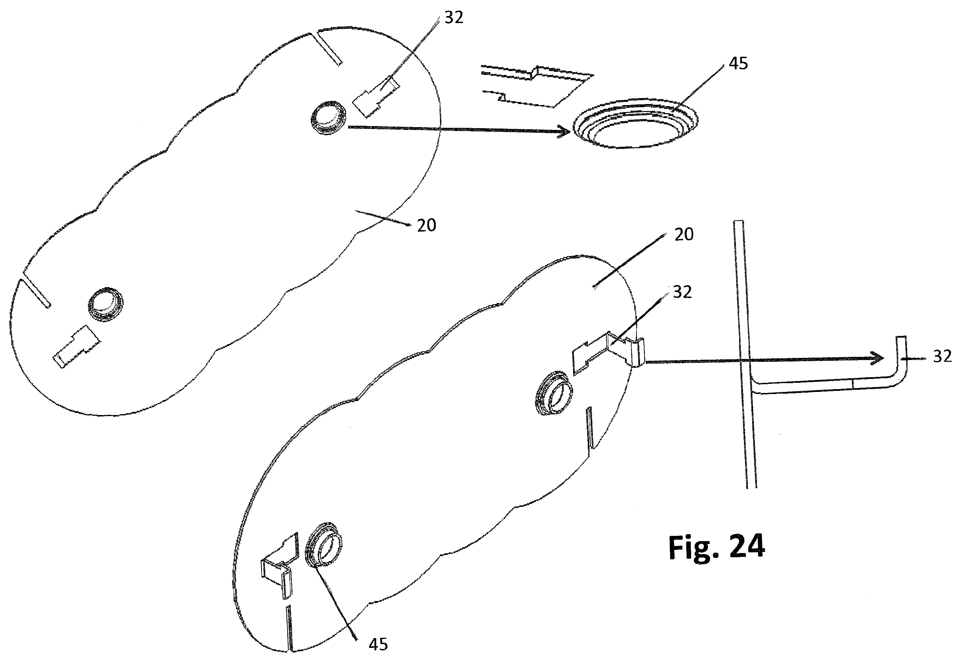

Fig. 24 zeigt eine bevorzugte Ausführungsform einer Kühllamelle 20, welche eine besonders haltbare Anbindung der Kühlkörperlamellen 20 an Wärmeleitrohren ermöglicht. Dazu wird zusätzlich zum Pass - bzw. Presssitz zwischen Wärmeleitrohr und Lamelle 20 im Bereich der Öffnung 38 für die Wärmeleitrohre ein vertiefter Umfangsbereich der Durchgangsöffnung für das Wärmeleitrohr vorgesehen - bspw. durch Tiefziehen mittels eines Formstempels nach Zuschneiden der Lamellen. Die so zwischen Wärmeleitrohr und Lamellenöffnung gebildete ringförmige Rinne 45 dient zur Aufnahme von Verbindung zwischen Wärmeleitrohr und Lamelle förderndem Material - bspw. von Klebern, Lötmaterial oder Füllmaterial. Bevorzugt werden wärmeleitende Kleber, wie sie dem Fachmann geläufig sind, eingesetzt. Besonders geeignet sind Kleber mit zugemischten gut wärmeleitenden Metallen. Durch den so gebildeten Kleberschichtring um das Wärmeleitrohr wird der mechanische und thermische Anschluss des Wärmeleitrohres an der Lamelle 20 verbessert.

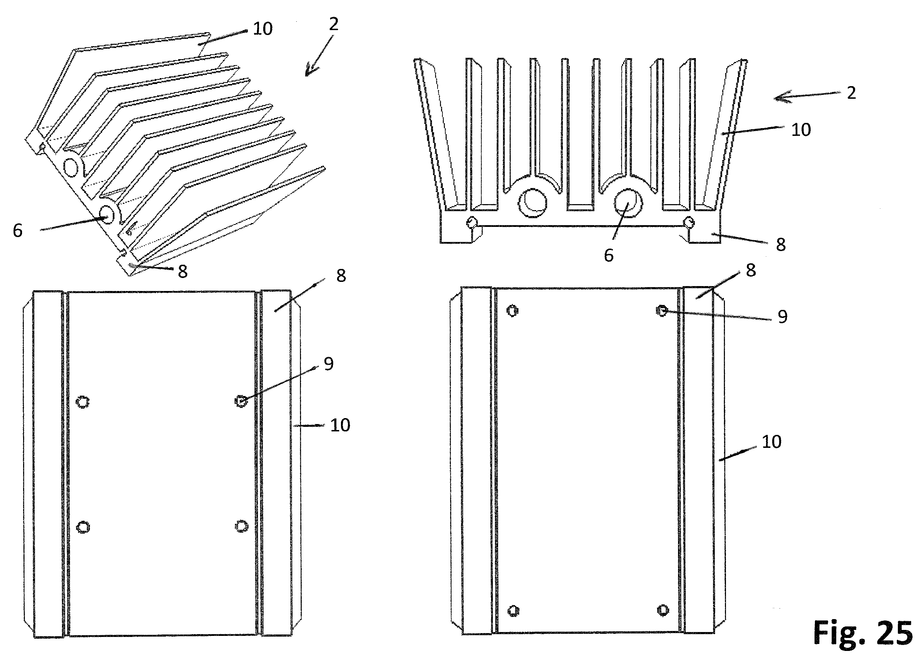

Fig. 25 verdeutlicht eine weitere Ausführungsform eines Kühlkörpers 3 mit relativ dickem Grundkörperbodenabschnitt, kurzen Seitenwänden und im Grundkörperbodenabschnitt verlaufenden Aufnahmeöffnungen 6 für Wärmeleitrohre in verschiedenen Ansichten.

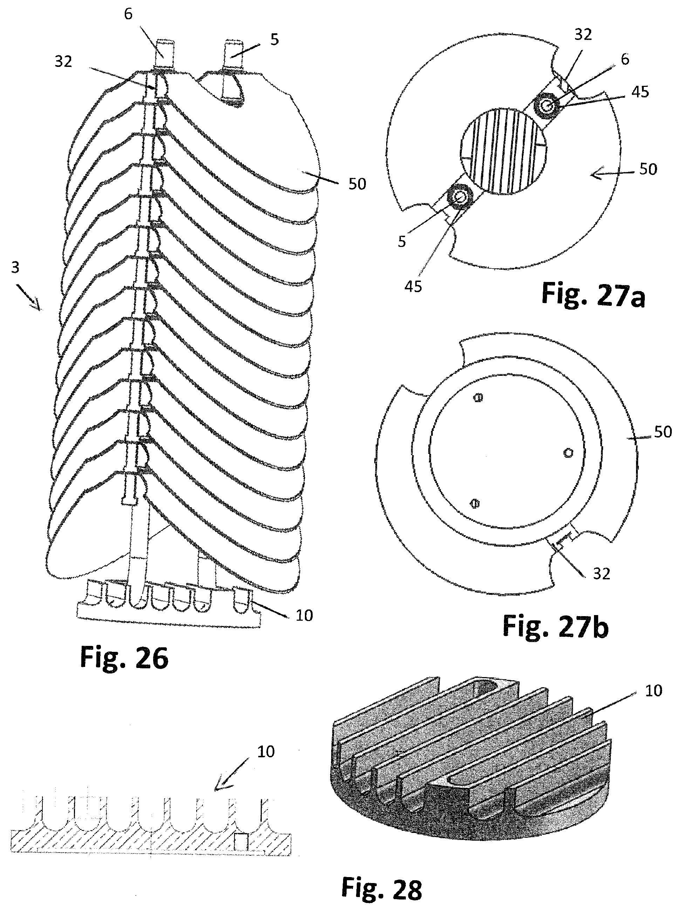

Fig. 26 stellt eine weitere Ausführungsform der Erfindung für recht kleine Lichtquellen, wie Punktlichtquellen, dar. Punktlichtquellen - auch als Spotlights bezeichnet - sind Lichtquellen geringer Außenmaße, die gezielt beleuchten. Sie sind häufig schwenkbar, um sich wechselnden zu beleuchtenden Objekten anzupassen und diese optisch hervorzuheben. Diese Spotlights haben zu diesem Zweck oberhalb der Lichtquelle eine schlanke Bauweise. Im vorliegenden Beispiel wird ein spezieller Kühllamellenkörper 3 geringen Durchmessers für Spotlight in perspektivischer Ansicht gezeigt. Die Kühlkörperlamellen 20 sind hier flügelartig abgebogen, so dass sie bei Betrachtung von unten einen geringen Durchmesser aufweisen und hinter der eigentlichen Lichtquelle, der LED, optisch wenig auffällig sind. Es ist dabei wichtig, dass geeignete Abstände zwischen den Lamellen - gesichert durch die Abstandshalter - eingehalten werden, um Luftzirkulation zu ermöglichen. Die abgebogenen Lamellenflügel werden z.Zt. bevorzugt in einem Winkel zum Wärmeleitrohr von zwischen 30 und 60 Grad, bevorzugt zwischen 40 und 50° angeordnet, um optimalen Luftaustausch für die Kühlung zu ermöglichen.

In Fig. 27 sind Draufsichten von oben und unten auf den Kühllamellenkörper 2 der Fig. 26 in Richtung der zentralen Öffnung gezeigt. Deutlich erkennt man in der Draufsicht von oben (Fig. 27a) die abgebogenen Lamellen 50 des Grundkörpers; während bei der Draufsicht von untern (Fig. 27b) die Befestigungsbohrungen für eine LED und die überstehenden abgebogenen Lamellen 50 zu sehen sind, sowie die die geringe optische Sichtfläche des Körpers zu erkennen.

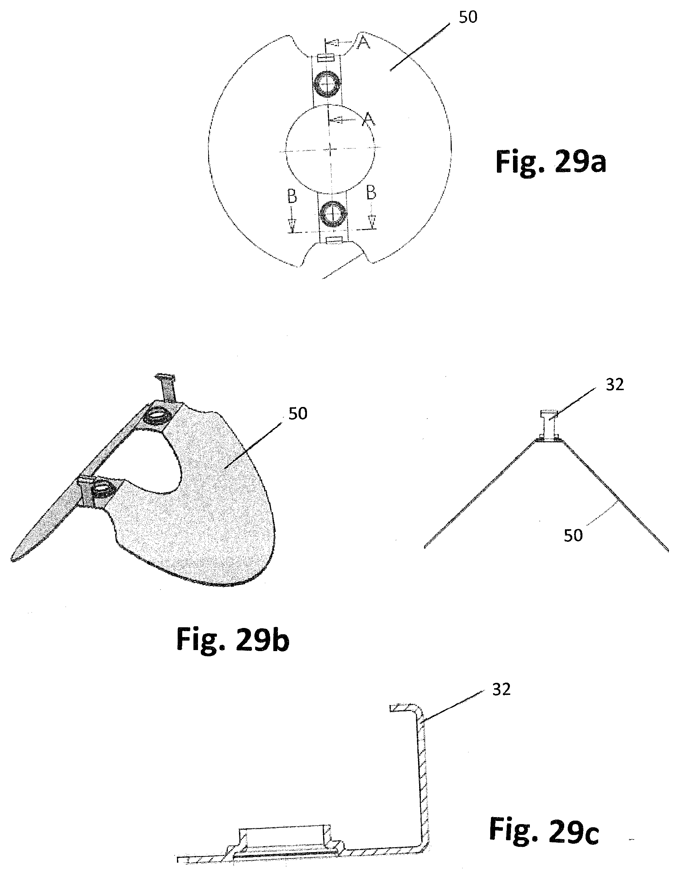

In Fig. 28 ist ein Beispiel für Spotlight-Grundkörper 2 für die Ausführungsform der Fig. 27 gezeigt. Die Befestigung über die in den Lamellen vorgesehene Vertiefung für die Wärmeleitrohre der Kühllamellenkörper der Fig. 26 und 27 ist dargestellt und der Umriss ist auf eine kreisförmige LED ausgerichtet. In Fig. 29 sind Detailansichten einer Spotlight-Kühllamelle 50 gezeigt. Die zentrale Öffnung zur Luftzirkulation, die abgebogenen Abstandshalter, die Aufnahmeöffnungen für die Wärmeleitrohre sind deutlich ersichtlich. Es ist auch ein Detail des Abstandshalters, der hier zu einer Auflage 32a umgebogen ist, dargestellt sowie durch den Wärmeleitrohraufnahmebereich mit Rinne 45 gezeigt.

Obwohl die Erfindung anhand eines bevorzugten Ausführungsbeispiels näher erläutert wurde, ist sie keineswegs auf dasselbe eingeschränkt sondern nur durch den Schutzumfang der beiliegenden Ansprüche bestimmt.

### Bezugszeichenliste

- 1.: Kühlvorrichtung, erste Ausführungsform.
- 2.: Grundkörper
- 3.: Kühlkörper
- 4.: Wärmeleitrohr
- 5.: Wärmeleitrohr
- 6.: Wärmeleitrohr
- 7.: Bodenteil
- 8.: Grundkörperseite
- 9.: Bohrung
- 10.: Lamelle (Grundkörper-)
- 11.: Befestigungsbohrung, seitliche
- 12.: LED-Modul (Wärmequelle)
- 13.: Metall-Gehäuseteil
- 14.: Kunststoff-Gehäuseteil
- 15.: Bodenteil-Kontaktfläche
- 16.: Heiße Zone (hot-spot)
- 17.: Metall-Gehäuseteil-Grundkörperseite
- 18.: Befestigungsbohrung
- 19.: Gewindebohrung
- 20.: Lamelle (Kühlkörper-)
- 21.: Bodenteilkontaktfläche
- 22.: Grundkörperkontaktfläche
- 24.: Leuchtzone (-Boden)
- 25.: Kühlvorrichtung, zweite Ausführungsform
- 26.: Nut
- 27.: Bogen
- 28.: Seitenlamelle
- 29.: Stanzloch
- 30.: Schlitz
- 32.: Abstandshalter
- 33.: Crimp-Ende von 4, 5
- 34.: glattes Ende von 4, 5
- 35.: Kühlvorrichtung, dritte Ausführungsform
- 36.: Auflageblech
- 37.: Auflageblech
- 38.: Bohrung
- 39.: Lampengehäuse
- 40.: Stromanschluss
- 41.: Befestigungsschraube
- 42.: Leitung
- 43.: Verbindungsbox
- 44.: LED-Treiber
- α: Neigungswinkel (Schräge)

## Patentansprüche

1. Kühlvorrichtung für eine Wärmequelle, insbesondere hochbestückte LED-Module, mit:
- einem Grundkörper (2), der mit dem Körper der Wärmequelle (12) in thermischem und mechanischem Kontakt steht,
- mindestens einem Wärmeleitrohr (4,5,6), dessen einer Endabschnitt formschlüssig und thermisch leitend im Grundkörper (2) eingelassen ist, und
- mindestens einem Kühlkörper (3) mit Kühlkörperlamellen (20) am anderen Endabschnitt des Wärmeleitrohrs wobei die Wärmeleitrohre (4, 5, 6) über die gesamte Länge des Grundkörpers (2) verlaufen;
die Wärmequelle (12) mit einer heißen Zone (16, 34) auf einer Kontaktfläche (21) des Grundkörpers (2) aufliegt,
die Wärmeleitrohre parallel zueinander beabstandet und parallel zur Kontaktfläche der Wärmequelle mit der heißesten Zone (16, 34) verlaufen;
der Grundkörper (2) am Körper der Wärmequelle (12) befestigt ist, und
- an der Außenseite des Grundkörpers (2) an diesem einteilig angeformte oder mit diesem verbundene Grundkörperlamellen (10) vorgesehen sind,
- die Kühlkörperlamellen (20) des Kühlkörpers (3) im Schrumpf- oder Presssitz auf den Wärmeleitrohren (4, 5, 6) in einem vorbestimmten Abstand zueinander vorliegen und zwischen den Kühllamellen (20) Abstandshalter (32) vorgesehen sind, die aus dem Lamellenblech ausgestanzte, aus der Lamellenhauptebene herausgebogene Zungen sind; und
**dadurch gekennzeichnet, dass**
- die Durchgangsöffnungen (38) für die Wärmeleitrohre (5, 6) der Kühlkörperlamellen (20) einen stufenartig tiefgezogenen Bereich (45) an ihrem Umfang aufweisen, sodass bei Durchtritt des Wärmeleitrohres Adhäsionsmaterial in der zwischen Wärmeleitrohr und Kühlkörperlamelle (20) gebildeten Rinne (45) ansammelbar ist.

2. Kühlvorrichtung nach Anspruch 1, **dadurch gekennzeichnet, dass** mindestens zwei Wärmeleitrohre (5, 6) vorgesehen sind, die außerhalb des Grundkörpers (2) stimmgabelartig auseinandergeführt sind und danach mit größerem Abstand zueinander parallel weiterverlaufen, wobei der Kühlkörper (3) durch den äußeren weiter zueinander beabstandeten Teilbereich der Wärmeleitrohre mit Kühlkörperlamellen (10) gebildet ist.

3. Kühlvorrichtung nach Anspruch 1, **dadurch gekennzeichnet, dass** drei Wärmeleitrohre vorgesehen sind, wobei ein mittig verlaufendes gerades Wärmeleitrohr (4) zwischen zwei äußeren, stimmgabelartig nach außen gebogenen Wärmeleitrohren (5, 6) in Art einer dreizinkigen Gabel, verläuft; wobei der Kühlkörper (3) durch den Teil mit parallel zueinander verlaufenden Teilbereichen der Wärmeleitrohre mit Kühlkörperlamellen (20) gebildet ist.

4. Kühlvorrichtung nach Anspruch 1, **dadurch gekennzeichnet, dass** die Wärmeleitrohre (4, 5, 6) in Bohrungen (9) des Grundkörpers (2) auf dessen gesamter Länge formschlüssig eingelassen oder in einer zur Kontaktfläche zwischen Grundkörper (2) und Wärmequelle (12) offenen Nut (26) eingelegt sind, so dass ein guter Kontakt zwischen den Wärmeleitrohren (5,6) und der Kontaktfläche (15) der Wärmequelle (12) besteht.

5. Kählvorrichtung nach Anspruch 1, **dadurch gekennzeichnet, dass** der Grundkörper (2) eine Platte mit äußeren, von der Kontaktfläche nach außen abragenden Grundkörperlamellen (10) ist.

6. Kühlvorrichtung nach Anspruch 5, **dadurch gekennzeichnet, dass** die Platte des Grundkörpers (2) dünner als der Durchmesser der Wärmeleitrohre ist und bogenartig (27) um die Wärmeleitrohre unter Ausbildung von Nuten (26) herumgeführt ist.

7. Kühlvorrichtung nach Anspruch 4, **dadurch gekennzeichnet, dass** der Grundkörper (2) mit Grundkörperbodenabschnitt (7) und Grundkörperseiten (8) die Wärmequelle (12) zumindest teilweise U-förmig seitlich umgreift, wobei die Grundkörperseiten (8) eine Fixierhilfe bieten.

8. Kühlvorrichtung nach mindestens einem der vorhergehenden Ansprüche, **dadurch gekennzeichnet, dass** im Grundkörperbodenabschnitt (7) Gewindebohrungen (19) zur Befestigung an der Wärmequelle (12) vorgesehen sind, die Bohrungen in der Wärmequelle (12) entsprechen, wobei ggf. zusätzliche Befestigungsbohrungen im Grundkörper (2) - spiegelbildlich zu ersteren - angeordnet sind, so dass ein Umdrehen der gesamten Kühlvorrichtung um 180° gegenüber der Wärmequelle (12) möglich ist.

9. Kühlvorrichtung nach Anspruch 1 oder 8, **dadurch gekennzeichnet, dass** die Kühlkörperlamellen (20, 50) rechteckig, mit bogenförmigen und flügelförmig abgebogenen Bereichen, oval oder wolkenartig eingekerbt, runde oder sonstige Blechzuschnitte, flügelartig abgebogen zur Erzielung einer geringeren Draufsichtfläche des Kühlkörpers (3) sind.

10. Kühlvorrichtung nach Anspruch 9, **dadurch gekennzeichnet, dass** die abgebogenen Kühlkörperlamellen eine zentrale Öffnung zur Luftzirkulation aufweisen.

11. Kühlvorrichtung nach mindestens einem der vorhergehenden Ansprüche, **dadurch gekennzeichnet, dass** an der unteren Auflagenseite der Kühlkörperlamellen (20) mindestens ein von unten nach oben oder innen führender Schlitz (30) zur Aufnahme von vertikalen Auflageblechen (36) vorgesehen ist.

12. Kühlvorrichtung nach einem der vorangehenden Ansprüche, **dadurch gekennzeichnet, dass** die Auflagebleche (36, 37) und die Wärmeleitrohre (4, 5, 6) eine in Endrichtung des Kühlkörpers (3) nach außen steigende Neigung besitzen, wodurch ein positiver Winkel "warme Seite" zu "kalter Seite" vorhanden ist.

13. Kühlvorrichtung nach Anspruch 1, **dadurch gekennzeichnet, daß** der Kühlkörper (3) über dem Grundkörper (2) angeordnet ist, wobei die an den Kühlkörper (3) anschließenden Wärmeleitrohre (5,6) U-förmig nach oben gebogen sind.

## Claims

1. Cooling element for a heat source, particularly for highly equipped LED modules, comprising:
one base body (2) that is in thermal and mechanical contact with a body of the heat source (12);
at least one heat pipe (4,5,6), whose end section is received in a form-fitting and thermally conducting manner in the base body (2); and
at least one cooling element (3) with cooling body lamellae (20) on the other end section of the heat pipe,
wherein:
the heat pipes (4,5,6) run over an entire length of the base body (2)
the hot zone (16,34) of the heat source (12) is evenly supported by a contact surface (21) of the base body (2),
where the heat pipes run parallel to each other spaced from another and parallel to a contact surface of the heat source with its hottest zone (16, 34),
the base body (12) is fastened to the body (2) of the heat source (12),
base body lamaellae (10) formed integrally with or connected to the base body (2) are provided,
cooling lamaellae (20) of the cooling body (3) are fixed by shrinkfit or pressfit on the heat pipes (4,5,6) at a predetermined distance from one another, whereby spacers (32) are provided between the cooling lamellae (20); that are punched out from lamellae sheets to form tongues, that are bent away from the lamella main plane,
characterized therein, that
through-holes (38) for the heat pipes (5,6) of the cooling body cooling lamellae (20) comprise a step-like deep drawn area in their circumference, so that after passing through the heat pipe, adhesive can collect in a groove (45) formed between the heat pipe and the cooling body lamella (20).

2. Cooling element according to claim 1, charactereized in that at least two heat pipes (5,6) are provided that, outside of the base body (2), lead away from each other in a pitchfork-like manner, and thereafter run parallel to one another with a larger distance between them, whereby the cooling body (3) is formed by an outer section of the heatpipes having greater distance therebetween with cooling body lamellae (20) provided thereto.

3. Cooling element according to claim 1, **characterized in that** three heat pipes are provided, whereby a straight central heat pipe (4) runs in the middle between two outer, pitchfork-shaped, heat pipes (5,6) that are bent outwardly in a three-pronged-fork-like manner, whereby the cooling body (3) is formed through a part thereof with parallel section areas of the heat pipes having cooling body lamellae (20).

4. Cooling element according to claim 1, **characterized in that** the heat pipes (4,5,6) are received in holes (9) along a whole length of the base body (2) or are set in a groove (26) that is open to the contact surface between the base body (2) and the heat source (12), so that there is good contact between the heat pipes (5,6) and the contact surface (15) of the heat source (12).

5. Cooling element according to claim 1, **characterized in that** the base body is a plate with exterior base body lamellae (10) extending from the contact surface.

6. Cooling element according to claim 5, characterized therein that the plate of the base body (2) is thinner than a diameter of the heat pipe and is arched (27) around the heat pipe while forming grooves (26).

7. Cooling element according to claim 4, characterized therein that the base body (2) with a base body section (7) and base body sides (8) at least partially wraps around the heat source (12) in a U-form, whereby the base body sides (8) provide support.

8. Cooling element according to at least one of the preceding claims, **characterized in that** the base body floor section (7) thread holes (19) are provided to fasten to the heat source (12) that correspond with holes in the heat source (12), whereby optionally additional fastening holes are provided in the base body (2) which mirror said threaded holes so that turning the entire cooling element by 180 degrees to the heat source (12) is possible.

9. Cooling element according to claim 1 or 8, **characterized in that** the cooling body lamellae (20, 50) are rectangular, with arch-shaped and wing-shaped sections, oval or cloud-like notches in an oval or cloud-like fashion, round or other metal cuttings, in order to ensure a minimal visible surface of the cooling body (3).

10. Cooling element according to claim 9, **characterized in that** the bent cooling body lamaellae have a central opening for air circulation.

11. Cooling element according to at least one of the preceding claims, characterized therein that on a lower side of the cooling body lamellae (20), at least one slit (30) running from top to bottom or leading inside is provided to accommodate vertical support sheets (36).

12. Cooling element according to at least one of the preceding claims, **characterized in that** the support sheets (36,37) and the heat pipes (4,5,6) rise in the direction of the top of the cooling body (3); whereby a positive angle "warm side" to "cold side" is obtained.

13. Cooling element according to claim 1 , **characterized in that** the cooling body (3) is placed above the base body (2) and the heat pipes (5, 6) connected to the cooling body (3) are bent upwards in a U-shape.

## Revendications

1. Dispositif de refroidissement pour une source de chaleur, en particulier des modules LED hautement ou densément équipés, présentant :
- un corps de base (2) qui est en contact thermique et mécanique avec le corps de la source de chaleur (12),
- au moins un tube thermoconducteur (4, 5, 6) dont une section d'extrémité est introduite par complémentarité de forme et de manière thermoconductrice dans le corps de base (2), et
- au moins un corps de refroidissement (3) présentant des lamelles de corps de refroidissement (20) sur l'autre section d'extrémité du tube thermoconducteur,
les tubes thermoconducteurs (4, 5, 6) s'étendant sur toute la longueur du corps de base (2) de sorte que la source de chaleur (12) repose, par une zone chaude (16, 34), sur une surface de contact (21) du corps de base (2),
les tubes thermoconducteurs s'étendant parallèlement à distance les uns des autres et parallèlement à la surface de contact de la source de chaleur présentant la zone la plus chaude (16, 34) et le corps de base (2) étant fixé au corps de la source de chaleur (12), et
- des lamelles de corps de base (10) formées d'un seul tenant sur le corps de base (2) ou reliées à ce dernier étant prévues sur la face extérieure de celui-ci,
- les lamelles de refroidissement (20) du corps de refroidissement (3) étant présentes en ajustement fretté ou serré sur les tubes thermoconducteurs (4, 5, 6) à une distance prédéterminée les unes des autres et des écarteurs (32) étant prévus entre les lamelles de refroidissement (10), qui sont des languettes découpées dans la tôle des lamelles et pliées hors du plan principal des lamelles ;
**caractérisé en ce que**
les ouvertures de passage (38) pour les tubes thermoconducteurs (5, 6) des lamelles de corps de refroidissement (20) présentent à leur périphérie une zone (45) emboutie en forme de gradin, de sorte que lors du passage du tube thermoconducteur, un matériau adhésif peut s'accumuler dans la gouttière (45) formée entre le tube thermoconducteur et la lamelle de corps de refroidissement (20).

2. Dispositif de refroidissement selon la revendication 1, **caractérisé en ce qu'**au moins deux tubes thermoconducteurs (5, 6) sont prévus, qui s'écartent l'un de l'autre en forme de diapason à l'extérieur du corps de base (2) et s'étendent ensuite parallèlement à plus grande distance l'un de l'autre, le corps de refroidissement (3) étant formé par la zone partielle extérieure des tubes thermoconducteurs plus espacés l'un de l'autre et présentant des lamelles de corps de refroidissement (10).

3. Dispositif de refroidissement selon la revendication 1, **caractérisé en ce que** trois tubes thermoconducteurs sont prévus, un tube thermoconducteur (4) droit s'étendant centralement entre deux tubes thermoconducteurs (5, 6) extérieurs, pliés vers l'extérieur en forme de diapason, de manière à former une fourchette à trois dents, le corps de refroidissement (3) étant formé par la partie présentant les zones partielles des tubes thermoconducteurs s'étendant parallèlement les unes aux autres et présentant des lamelles de corps de refroidissement (20).

4. Dispositif de refroidissement selon la revendication 1, **caractérisé en ce que** les tubes thermoconducteurs (4, 5, 6) sont introduits par complémentarité de forme dans des trous (9) du corps de base (2) sur toute sa longueur ou insérés dans une rainure (26) ouverte vers la surface de contact entre le corps de base (2) et la source de chaleur (12), de sorte qu'il existe un bon contact entre les tubes thermoconducteurs (5, 6) et la surface de contact (15) de la source de chaleur (12).

5. Dispositif de refroidissement selon la revendication 1, **caractérisé en ce que** le corps de base (2) est une plaque présentant des lamelles de corps de base (10) extérieures, en saillie vers l'extérieur de la surface de contact.

6. Dispositif de refroidissement selon la revendication 5, **caractérisé en ce que** la plaque du corps de base (2) est plus mince que le diamètre des tubes thermoconducteurs et enroulée en forme d'arc (27) autour des tubes thermoconducteurs en formant des rainures (26).

7. Dispositif de refroidissement selon la revendication 4, **caractérisé en ce que** le corps de base (2) présentant une section de fond de corps de base (7) et des côtés de corps de base (8) entoure latéralement la source de chaleur (12) en forme de U au moins partiellement, les côtés de corps de base (8) offrant une aide à la fixation.

8. Dispositif de refroidissement selon l'une des revendications précédentes, **caractérisé en ce que** dans la section de fond de corps de base (7) sont prévus des trous filetés (19) pour la fixation à la source de chaleur (12), qui correspondent à des trous dans la source de chaleur (12), des trous de fixation supplémentaires étant éventuellement disposés dans la corps de base (2) - selon une symétrie spéculaire par rapport aux premiers -, de sorte qu'une rotation de l'ensemble du dispositif de refroidissement de 180° par rapport à la source de chaleur (12) est possible.

9. Dispositif de refroidissement selon les revendications 1 ou 8, **caractérisé en ce que** les lamelles de corps de refroidissement (20, 50) sont des découpes de tôle rectangulaires, avec des zones en forme d'arc et pliées en forme d'ailette, ovales ou entaillées en forme de nuage, rondes ou autres, en forme d'ailette pour obtenir une plus faible surface du corps de refroidissement (3) en vue de dessus.

10. Dispositif de refroidissement selon la revendication 9, **caractérisé en ce que** les lamelles de corps de refroidissement pliées présentent une ouverture centrale pour la circulation de l'air.

11. Dispositif de refroidissement selon au moins l'une des revendications précédentes, **caractérisé en ce qu'**au moins une fente (30) menant du bas vers le haut ou vers l'intérieur pour la réception de tôles d'appui verticales (36) est prévue sur le côté d'appui inférieur des lamelles de corps de refroidissement (20).

12. Dispositif de refroidissement selon l'une des revendications précédentes, **caractérisé en ce que** les tôles d'appui (36, 37) et les tubes thermoconducteurs (4, 5, 6) possèdent une inclinaison en pente montante vers l'extérieur dans la direction longitudinale du corps de refroidissement (3), de sorte qu'un angle positif « côté chaud » vers « côté froid » est présent.

13. Dispositif de refroidissement selon la revendication 1, **caractérisé en ce que** le corps de refroidissement (3) est disposé sur le corps de base (2), les tubes thermoconducteurs (5, 6) qui font suite au corps de refroidissement (3) étant pliés vers le haut en forme de U.
